## Europäisches Patentamt

## European Patent Office

## Office européen des brevets

(19)

(11) Veröffentlichungsnummer: **0 360 936**
**A1**

(12) **EUROPÄISCHE PATENTANMELDUNG**

(21) Anmeldenummer: **88309066.4**

(22) Anmeldetag: **29.09.88**

(51) Int. Cl.5: **H03M 1/12**

(43) Veröffentlichungstag der Anmeldung:
**04.04.90 Patentblatt 90/14**

(84) Benannte Vertragsstaaten:
**AT BE CH DE FR GB IT LI LU NL SE**

(71) Anmelder: **Siemens Aktiengesellschaft Österreich**
**Siemensstrasse 88 - 92**
**A-1210 Wien(AT)**

(72) Erfinder: **Bustance, C. David**
**Craig Cottage 15 Fowlmere Road**
**Royston Hertfordshire(GB)**
Erfinder: **Lidbetter, Paul**
**76 Chapel Lane**
**Fowlmere Royston Hertfordshire(GB)**
Erfinder: **Lancaster, John**
**14 Cherry Orchard**
**Fulbourn Cambridge(GB)**

(54) **Verfahren zur Wandlung des Abtastsignals eines analogen Eingangssignals.**

(57) Ein analoges Audiosignal wird nach einer Frequenzbegrenzung von einem Abtast-Halteglied (SH) zur Umwandlung in einen L-Bit Ausgangswert gehalten. Das Abtastsignal wird von einem Parallel-A/D-Wandler (FAD) in einen digitalen Referenzwert zu M < L Datenbits umgewandelt, der einerseits die höherwertigeren Bits des Ausgangswertes bildet und andererseits mit einem Referenz-D/A-Wandler (RDA) rückgewandelt wird. Dieses Referenzsignal wird vom Abtastsignal subtrahiert, das Differenzsignal verstärkt und in einen Teilwert zu M < L < L Datenbits umgewandelt. Der Teilwert bildet die niederwertigeren Bits des Ausgangswertes, wobei ein mit dem Referenzwert überlappendes Bit zur Fehlerkorrektur verwendet wird.

EP 0 360 936 A1

Fig. 1

## Verfahren zur Wandlung des Abtastsignals eines analogen Eingangssignals

Die Erfindung betrifft ein Verfahren zur Wandlung des Abtastsignals eines analogen Eingangssignals in einen digitalen Ausgangswert zu L Datenbits.

Ein derartiges Verfahren wird beispielsweise in der AT-PS 374.293 beschrieben. Bei Audiosignalen ist zum Erhalten einer guten Klangqualität auf hohe Auflösung und gute Linearität zu achten. Die übliche Verarbeitung mit 16-Bit-Wörtern gibt die Möglichkeit, das Audiosignal in ± 32.767 diskrete Werte aufzulösen. Insbesondere bei niederen Signalpegeln kann diese Auflösung aber ungenügend sein.

Der Erfindung liegt die Aufgabe zugrunde, die Auflösung der Wandlung zu verbessern.

Dies wird gemäß Patentanspruch 1 dadurch erreicht, daß das Abtastsignal in einen digitalen Referenzwert zu $M < L$ Datenbits umgewandelt wird, der wiederum in ein analoges Referenzsignal rückgewandelt und vom Abtastsignal subtrahiert wird, daß dieses Differenzsignal verstärkt und in einen digitalen Teilwert zu $M < N < L$ Datenbits umgewandelt wird, der mit dem Referenzwert zum Ausgangswert mit L Datenbits zusammengefaßt wird, wobei vom Referenzwert die höherwertigeren und vom Teilwert die niederwertigeren Datenbits des Ausgangswertes gebildet werden und die Summe der Anzahl der Datenbits von Referenz- und Teilwert nicht kleiner als die Anzahl der Datenbits des Ausgangswertes ist.

Der Referenzwert ist eine erste Näherung des Ausgangswertes. Das Differenzsignal enthält die Information, die unterhalb der Auflösungsgrenze des Referenzwertes liegt. Gerade in diesem Bereich kleiner Eingangssignalpegel wird daher eine hohe Auflösung und gute Linearität erzielt. Durch die Aufteilung der Wandlung in die Bildung des Referenz- und des Teilwertes wird nach deren Zusammenfassung eine Gesamtauflösung erreicht, die größer als die jeweilige Teilauflösung ist. Da weiters der Teilwert bei der Bildung des Ausgangswertes nach unten verschoben wird, werden alle Fehler bei der Teilwertbildung im Verhältnis zum Ausgangswert abgesenkt.

Zur optimalen Ausnutzung der verwendeten Bauelemente ist es vorteilhaft, daß die Summe der Datenbits von Referenz- und Teilwert nicht wesentlich größer als die Anzahl der Datenbits des Ausgangswertes ist und daß die überzähligen Datenbits zur Korrektur von Umwandlungsfehlern und zur Anzeige eines Überschreitens des Wertebereichs verwendet werden. Die Überlappung des Referenz- mit dem Teilwert ermöglichst es, mit dem höchstwertigsten Bit des Teilwertes die Fehler bei der Referenzwertbildung zu eliminieren. Spannungsspitzen bei der Bildung des Differenzsignals durch Laufzeitdifferenzen zwischen dem Abtastsignal und dem Referenzsignal werden dadurch auf ein nicht mehr störendes Maß reduziert, daß der Referenzwert nur während einer Abtastperiode als Teil eines Arbeitszyklus gebildet und bis zur nächsten Abtastperiode gehalten wird und daß die Subtrahierung des Referenzsignals unterdrückt wird, wenn der Pegel des Abtastsignals unter das minimale Quantisierungsniveau zur Referenzwertbildung absinkt. Weiters erübrigt sich durch diese Betriebsweise ein Haltespeicher am Wandlerausgang.

Bei der Digital/Analog-Wandlung wird eine hohe Gesamtauflösung unter Verwendung niedriger auflösender Bauelemente dadurch erreicht, daß ein digitaler Eingangswert in zwei Teilwerte aufgespalten und in analoge Teilsignale umgewandelt wird, wobei die höherwertigeren Bits des Eingangswertes den oberen Teilwert bilden und gleichzeitig mit den niederwertigeren Bits in analoge Teilsignale umgewandelt werden, wobei die Zahl der höherwertigeren Bits kleiner als die Zahl der niederwertigeren Bits ist und daß die Teilsignale zu einem Summensignal zusammengefaßt werden.

Temperaturschwankungen bei der Strom-Spannungswandlung zur Teilsignalbildung und der Summierung und die Alterung der verwendeten Bauteile löst hörbare Verzerrungen bei Signalen mit niederem Pegel aus. Diese Verzerrungen werden dadurch beseitigt, daß ein digitaler Gleichstrom zum Eingangswert addiert und das Teilsignal des oberen Teilwertes gedämpft wird, wenn Eingangswerte kleiner als der digitale Gleichstrom sind. Dabei kommt es zu einer Entkopplung des Spannungsnulldurchganges der Wandler vom bipolaren Nullpunkt des Eingangswertes. Weiters wird dadurch auch der Rauschpegel bei der Wandlung gesenkt.

Zur Durchführung der Analog/Digital-Wandlung mit gängigen Bauteilen ist es vorteilhaft, daß das Eingangssignal einem Abtast-Halteglied zugeführt ist, dessen Ausgang mit dem Analogeingang eines M-Bit Parallel-A/D-Wandlers verbunden ist, daß die Ausgänge des Parallel-A/D-Wandlers mit den Digitaleingängen eines Referenz-D/A-Wandlers und den höherwertigeren Eingängen eines L-Bit bistabilen Haltespeichers verbunden sind, daß der Ausgang des Referenz-D/A-Wandlers mit dem Ausgang des Abtast-Haltegliedes in einem Differenzverstärker zusammengeführt ist, dessen Ausgang mit dem Analogeingang eines N-Bit Teilwert-A/D-Wandlers verbunden ist und daß die Ausgänge des Teilwert-A/D-Wandlers mit den niederwertigeren Eingängen des Haltespeichers verbunden sind. Durch die schnelle Arbeitsweise des Parallel-A/D-Wandlers wird die Laufzeitdifferenz zwischen Abtast- und Referenzsignal so gering als möglich gehalten.

Zur Durchführung einer Fehlerkorrektur sind Eingänge einer Korrekturschaltung mit den Ausgängen des Parallel-A/D-Wandlers verbunden, ist ein weiterer Eingang der Korrekturschaltung mit dem höchstwertigsten Ausgang des Teilwert-A/D-Wandlers verbunden, sind Ausgän ge der Korrekturschaltung mit den höherwertigeren Eingängen des Haltespeichers, ein Überlastausgang der Korrekturschaltung mit einem weiteren Eingang des Haltespeichers und ein Steuerausgang der Korrekturschaltung mit einer Rauschunterdrückungsschaltung verbunden und ist die Rauschunterdrückungsschaltung zwischen den Referenz-D/A-Wandler und den Differenzverstärker geschaltet. Die Ausgabe des Überlastwertes ersetzt eine analoge Überlastanzeige.

Zur Digital/Analog-Wandlung mit gängigen Bauteilen ist es vorteilhaft, daß ein Datenbus für Eingangswerte mit einem Niederwert- und einem Oberwert-D/A-Wandler verbunden ist, deren Ausgänge in einem Summierverstärker zusammengefaßt sind. Ein Gleichstromaddierer ist zwischen dem Oberwert-D/A-Wandler und dem Summierverstärker angeordnet und über einen Aufnahmespeicher mit dem Datenbus und über ein Gatter mit dem Eingang des Oberwert-D/A-Wandlers verbunden. Um sicherzustellen, daß bei einem Vielkanal-Audiosystem alle Kanäle zum selben Zeitpunkt die Eingangswerte übernehmen und keine Phasenfehler auftreten, ist mit dem Aufnahmespeicher ein Übertragungsspeicher in Serie geschaltet.

Die Erfindung wird anhand eines Ausführungsbeispieles mit zwei Zeichnungen näher erläutert. Es zeigen:

Fig. 1 ein Blockschaltbild der Analog/Digital-Wandlerbaugruppe und

Fig. 2 ein Blockschaltbild der Digital/Analog-Wandlerbaugruppe des Ausführungsbeispieles.

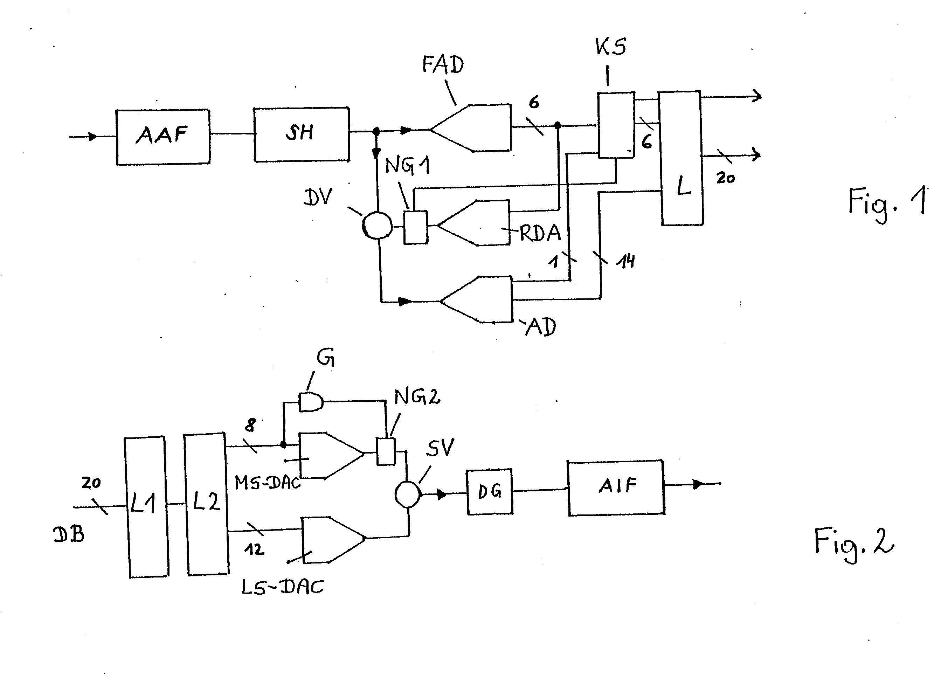

In Fig. 1 wird das Blockschaltbild einer 20-Bit Analog/Digital-Wandlerbaugruppe eines Tonkanales eines digitalen Studiomischpultes mit linearer Wandlercharakteristik gezeigt. Ein analoges Audiosignal liegt am Eingang eines Echofilters AAF an, der die Tonfrequenz auf maximal 20 kHz begrenzt. Aus diesem Signal wird von einem Abtast-Halteglied SH mit 48 kHz ein pulsamplitudenmoduliertes Abtastsignal mit diskreter Gleichspannung erzeugt, das in zwei parallelen Schritten in einen digitalen Ausgangswert umgewandelt wird.

Ein schneller 6-Bit Parallel-A/D-Wandler FAD erzeugt einen digitalen 6-Bit Näherungswert des Abtastsignals. Dieser Referenzwert wird einerseits einem Haltespeicher L als Teil des Ausgangswertes zugeleitet, andererseits von einem 16-Bit Referenz-D/A-Wandler RDA in ein analoges Referenzsignal rückgewandelt und mit einem Differenzverstärker DV vom Abtastsignal subtrahiert. Dieses Differenzsignal wird um den Faktor 32 verstärkt und einem 16-Bit Teilwert-A/D-Wandler AD zugeführt. Dieser ist zur besseren Linearität auf 15-Bit kurzgeschlossen. Das nunmehr höchstwertigste Bit des Teilwertes wird einer Korrekturschaltung KS zugeleitet und als digitaler Überlagerungswert zur Korrektur von Fehlern bei der Referenzwertbildung des Parallel-A/D-Wandlers FAD herangezogen. Es wird zum 6-Bit Referenzwert addiert, der gemeinsam mit dem Teilwert den 20-Bit Ausgangswert des analogen Audiosignals bildet. Im Haltespeicher L werden der Referenzwert als höherwertiger Teil und die verbliebenen 14-Bits des Teilwertes als niederwertiger Teil des Ausgangswertes zusammengefaßt.

Ist ein Audiosignal unter dem minimalen Quantisierungsniveau des Parallel-A/D-Wandlers FAD, so wird die Bildung des Referenzsignals unterdrückt. In diesem Fall beträgt daher der Verstärkungsfaktor des Differenzverstärkers DV 64. Das Signalniveau am Eingang des Teilwert-A/D-Wandler AD ist immer um 36 dB höher als am Eingang der gesamten Baugruppe. Bei der Bildung des Ausgangswertes wird der Teilwert dann um 36 dB nach unten verschoben. Damit werden alle bei der Wandlung auftretenden Fehler des Teilwert-A/D-Wandlers AD um 36 dB abgesenkt. Das ergibt eine sehr gute Linearität des Ausgangswertes für Audiosignale, deren Pegel mehr als 36 dB unter dem Maximalwert liegt. Die einzige Begrenzung der Gesamtgenauigkeit der Analog/Digital-Wandlung bei Abtastsignalen oberhalb des minimalen Quantisierungsniveaus des Parallel-A/D-Wand lers FAD ist bei Verwendung der Korrekturschaltung KS die Genauigkeit des Referenz-D/A-Wandlers RDA.

Der Echofilter AAF besteht aus einem Standard-Neve-Filter EM 10052, der über einen Operationsverstärker (1/2 NE 5532) mit einem Butterworth-Tiefpaßfilter vierter Ordnung verbunden ist. Im Abtast-Halteglied SH wird die Isolation zwischen dem Abtastsignal und den Haltekondensatoren durch zwei duale Feldeffekttransistoren (2x N 5911) verbessert. Eine Entladung der Haltekondensatoren wird durch Integration mit einem Operationsverstärker (LF 356) verhindert.

Der Parallel-A/D-Wandler FAD ist unipolar und vom Typ MP 7682. Die Ausgangsspannung des Abtast-Haltegliedes SH wird über Widerstände entsprechend angepaßt. Der Parallel-A/D-Wandler FAD wird in einem Teilmodus betrieben. Er wird während eines Arbeitszyklus nur in der Abtastperiode mit 3,072 MHz getaktet und verbleibt bis zur nächstfolgenden Abtastperiode in Bereitschaftsstellung. Dabei wird der letzte Wert am Wandlerausgang bis zur nächsten Taktimpulsfolge gehalten.

Zur Erzielung einer hohen Genauigkeit wird ein 16-Bit-Wandler (PCM 54 KP) als Referenz-D/A-Wandler RDA verwendet und so beschaltet, daß er als 6-Bit Wandler arbeitet. Dieser Wandler bestimmt wesentlich die Genauigkeit des Ausgangswertes der gesamten Baugruppe. Zur Verminderung des Rauschens wird statt des Spannungsausganges der Stromausgang verwendet und das Spannungssignal durch zwei rauscharme Operationsverstärker erzeugt. Die sechs Ausgangsbits des Parallel-A D-Wandlers FAD werden den sechs höchstwertigsten Eingängen des Referenz-D/A-Wandlers RDA zugeleitet. Eine Rauschunterdrükkungsschaltung NG1, bestehend aus einem Feldeffekttransistor (J 110) und einem Widerstand (200 Ohm), ist als Spannungsteiler mit dem Referenz-D/A-Wandlers RDA verbunden. Sie senkt die Referenzspannung um etwa 26 dB ab, wenn kein gültiger Wert am Eingang des Referenz-D/A-Wandlers RDA anliegt. Ein gültiger Wert am Ausgang des Parallel-D/A-Wandlers FAD bewirkt das Abschalten des Feldeffekttransistors, und der Ausgang des Referenz-D/A-Wandlers RDA wird mit dem Differenzverstärker DV verbunden.

Der Differenzverstärker DV besteht aus einem Operationsverstärker (NE 5534), der invertierend an virtueller Erde betrieben wird. Der nominelle Spannungsverstärkungsfaktor ist 8. Das Abtastsignal am Ausgang des Abtast-Halteliedes SH wird mit dem invertierten Referenzsignal gemischt. Aus diesem Differenzsignal wird durch den Teilwert-A/D-Wandler AD der Teilwert gebildet. Eine Verzögerung zwischen dem Abtastsignal und dem Referenzsignal am Eingang des Differenzverstärkers DV kann Spannungsspitzen erzeugen. Insbesondere bei hochfrequenten Audiosignalen käme es dann zu starken harmonischen Verzerrungen. Um dieses Problem zu lösen, könnte der Ausgang des Differenzverstärkers DV durch einen Analogschalter solange abgeschaltet werden, bis das Differenzsignal stabil ist. Zur Impedanzanpassung dieses Analogschalters an den Teilwert-A/D-Wandler AD wäre aber ein zusätzlicher Operationsverstärker notwendig. Bei diesem Ausführungsbeispiel werden die Laufzeitdifferenzen und die daraus resultierenden Spannungsspitzen aber bereits dadurch auf ein nicht mehr störendes Maß reduziert, daß der Referenz-D/A-Wandler RDA im Teilmodus betrieben wird. Spannungsspitzen treten nur auf, wenn das Abtastsignal über dem minimalen Quantisierungsniveau des Parallel-A/D-Wandlers FAD ist. Andernfalls ist, wie bereits beschrieben, der Ausgang des Referenz-D/A-Wandlers RDA durch die Rauschunterdrückungsschaltung NG1 abgeschaltet.

Der Teilwert-A/D-Wandler AD bildet aus dem Differenzsignal die niederwertigeren Bits des digitalisierten Audiosignals. Es wird ein 16-Bit-Wandler (PCM 75) verwendet, der für 15-Bit Operationen kurzgeschlossen ist. In der noch verbleibenden Periodenzeit eines Arbeitszyklus von 13 μsec wird das Differenzsignal in den Teil wert umgewandelt.

Der Spannungsbereiche am Eingang des Teilwert-A/D-Wandlers AD für das Differenzsignal ist auf ein Viertel des Spannungsbereiches des Audiosignals festgelegt. Das entspricht einem Verstärkungsfaktor 4. Zusammen mit dem Verstärkungsfaktor 8 des Operationsverstärkers im Differenzverstärker DV wird der gesamte Verstärkungsfaktor von 32, oder 30 dB, im analogen Bereich erreicht. Durch das Verschieben des digitalen Teilwertes wird eine weitere Verstärkung um 6 dB erreicht, da das 15. Bit (MSB) zur Fehlerkorrektur verwendet wird. Das nächstniederwertigere Bit ist Bit 7 des 20-Bit Ausgangswertes am Haltespeicher L.

Die Hauptaufgabe der Korrekturschaltung KS ist es, das höchstwertigste Bit des Teilwert-A/D-Wandlers AD zum niederwertigsten Bit des Parallel-A/D-Wandlers FAD zu addieren. Dieses Korrekturbit enthält alle Fehler, die bei der Parallelwandlung des Abtastsignals auftreten könnten. Bei Verwendung eines Binäraddierers (74LS 283) müßte das Ausgangssignal digital begrenzt werden, um ein Überschreiten des Wertebereichs zu verhindern. Durch Verwendung eines programmierbaren Lesespeichers (AM27 S29) wird das Additionsergebnis auf Werteüberlauf geprüft und gegebenenfalls auf den Maximalwert (h3F) abgesenkt. Zusätzlich wird dann ein Überlastwert erzeugt. Der Ausgangswert wird in das Format des komplementären Zweierkomplements invertiert. Zeigt der Ausgang des Parallel-A/D-Wandlers FAD ein Unterschreiten des minimalen Quantisierungsniveaus an (h1F), so wird über die Korrekturschaltung KS die Rauschunterdrückungsschaltung NG1 aktiviert.

Im Haltespeicher L (3x LS 374) werden Teilwert und Referenzwert zum 20-Bit Ausgangswert zusammengeführt. Der 6-Bit Referenzwert bildet die höherwertigeren und der 14-Bit Teilwert die niederwertigeren Bits des Ausgangswertes. Zusätzlich wird der Überlastwert ausgegeben.

Fig. 2 zeigt die Digital/Analog-Wandlerbaugruppe, die einen 20-Bit Eingangswert in ein analoges Audiosignal umwandelt. Der Eingangswert wird von einem Datenbus DB in einen Aufnahmespeicher L1 übernommen und an einen Übertragungsspeicher L2 weitergeleitet. Aufnahme- und Übertragungsspeicher L1, L2 sind aus D-Flip-Flops (je 5x 74LS 374) aufgebaut. Vom Übertragungsspeicher L2 werden die acht höherwertigen Bits als Näherung des Eingangswertes invertiert zu einem Oberwert-D/A-Wandler MS-DAC übertragen. Die zwölf niederwertigeren Bits werden direkt einem Niederwert-D/A-Wandler LS-DAC zugeleitet.

Als Niederwert- und Oberwert-D/A-Wandler LS-DAC, MS-DAC werden preiswerte PCM 54 KP Wandler verwendet. Dadurch kann eine leistungsfähige, lineare 20-Bit Digital Analog-Wandlerbaugruppe mit einer Arbeitsfrequenz vom bis zu Vierfachen der Abtastrate von 48 kHz aufgebaut werden. Bevor die Ausgänge des Niederwert-und Oberwert-D/A-Wandlers LS-DAC, MS-DAC summiert werden, müssen die Pegel so angepaßt werden, daß der Wert des höchstwertigen Bits des Niederwert-D/A-Wandlers LS-DAC die Hälfte des Wertes des niederwertigsten Bits des Oberwert-D/A-Wandlers MS-DAC beträgt. Das bedeutet, daß das Teilsignal am Ausgang des Niederwert-D/A-Wandlers LS-DAC um 48 dB zu dämpfen ist. Dies geschieht in zwei Stufen. In der ersten wird der digitale Eingangswert des Niederwert-D/A-Wandlers LS-DAC um vier Bits nach unten verschoben, was einer Dämpfung um 24 dB entspricht. Die restliche Dämpfung erfolgt bei der Strom-Spannungswandlung des analogen Teilsignals.

Da der Spannungsausgang der verwendeten Wandlertypen einen hohen Rauschpegel aufweist, der teilweise durch den internen Strom-Spannungsverstärker verursacht wird, werden extern rauscharme Operationsverstärker (NE 5532) zur Strom-Spannungswandlung verwendet. Durch eine zweite Verstärkerstufe mit einem invertierenden Operationsverstärker an virtueller Erde wird in einem Summier verstärker SV die Ausgangsspannung des Oberwert-D/A-Wandlers MS-DAC um 19,2 dB angehoben und im Niederwert-D/A-Wandler LS-DAC um 4,8 dB abgesenkt. Damit ist die genaue Pegelanpassung der beiden Teilsignale vollzogen. Die Summenbildung erfolgt in einem rauscharmen Operationsverstärker (NE 5532) mit Verstärkungsfaktor 1.

Temperaturschwankungen bei der Strom-Spannungswandlung und der Summierung und die Alterung der verwendeten Komponenten lösen hörbare Verzerrungen bei Signalen mit niederem Pegel aus. Zur Beseitigung dieser Fehlerquelle wird ein Gleichstromaddierer NG2 verwendet. Ein digitaler Gleichstrom wird zum Eingangswert addiert, wodurch der Spannungsnulldurchgang der Wandler vom bipolaren Nullpunkt des Eingangswertes getrennt wird. Der digitale Gleichstrom senkt auch den Rauschpegel, der durch die Digital/Analog-Wandlung im Wandler erzeugt wird. Ein NAND-Gatter G mit acht Eingängen (74LS 30) wird mit den acht Bits des Teilwertes des Oberwert-D/A-Wandlers MS-DAC verbunden. Der Ausgang dieses Gatters G ist mit dem Gleichstromaddierer NG2 verbunden, der als Spannungsteiler aus einem Widerstand (390 Ohm) und einem Feldeffekttransistor (J 110) aufgebaut ist. Bei Eingangswerten kleiner als der digitale Gleichstrom wird der Feldeffekttransistor über das Gatter G eingeschaltet und der Ausgang des Oberwert-D/A-Wandlers MS-DAC um etwa 30 dB gedämpft. Der Ausgang des Niederwert-D/A-Wandlers LS-DAC wird wie beschrieben immer um 24 dB gedämpft. Dessen Rauschpegel stellt somit kein Problem dar. Durch den Gleichstromaddierer NG2 wird der Dynamikumfang der gesamten Digital/Analog-Wandlerbaugruppe größer als 122 dB. Der Teilwert am Eingang des Oberwert-D/A-Wandlers MS-DAC wird invertiert. Um die Leistungsfähigkeit der Baugruppe auch bei größeren Signalpegeln zu erhalten, sollen nur Bauteile mit kleinen Temperaturkoeffizienten verwendet werden.

Das Summensignal wird nach dem Summier verstärker SV einem Glättungsfilter DG zugeführt. Nach einem Ausgangsfilter AIF mit sin x/x Kompensation kann der Pegel des Ausgangssignals gegebenenfalls noch durch einen invertierenden Operationsverstärker justiert werden.

## Ansprüche

1. Verfahren zur Wandlung des Abtastsignals eines analogen Eingangssignals in einen digitalen Ausgangswert zu L Datenbits, **dadurch gekennzeichnet,** daß das Abtastsignal in einen digitalen Referenzwert zu M < L Datenbits umgewandelt wird, der wiederum in ein analoges Referenzsignal rückgewandelt und vom Abtastsignal subtrahiert wird, daß dieses Differenzsignal verstärkt und in einen digitalen Teilwert zu M < N < L Datenbits umgewandelt wird, der mit dem Referenzwert zum Ausgangswert mit L Datenbits zusammengefaßt wird, wobei vom Referenzwert die höherwertigeren und vom Teilwert die niederwertigeren Datenbits des Ausgangswertes gebildet werden und die Summe der Anzahl der Datenbits von Referenz- und Teilwert nicht kleiner als die Anzahl der Datenbits des Ausgangwertes ist.

2. Verfahren nach Anspruch 1, **dadurch gekennzeichnet,** daß die Summe der Datenbits von Referenz- und Teilwert nicht wesentlich größer als die Anzahl der Datenbits des Ausgangwertes ist und daß die überzähligen Datenbits zur Korrektur von Umwandlungsfehlern und zur Anzeige eines Überschreiten des Wertebereiches verwendet werden.

3. Verfahren nach Anspruch 1 oder 2, **dadurch gekennzeichnet,** daß der Referenzwert nur während einer Abtastperiode als Teil eines Arbeitszyklus gebildet und bis zur nächsten Abtastperiode gehalten wird und daß die Subtrahierung des Referenzsignals unterdrückt wird, wenn der Pegel des Abtastsignals unter das minimale Quantisierungsniveau zur Referenzwertbildung absinkt.

4. Verfahren nach einem der vorherigen Ansprüche, **dadurch gekennzeichnet,** daß ein digitaler Eingangswert in zwei Teilwerte aufgespalten und in analoge Teilsignale umgewandelt wird, wobei die höherwertigeren Bits des Eingangswertes den oberen Teilwert bilden und gleichzeitig mit den niederwertigeren Bits in analoge Teilsignale umgewandelt werden, wobei die Zahl der höherwertigeren Bits kleiner als die Zahl der niederwertigeren Bits ist und daß die Teilsignale zu einem Summensignal zusammengefaßt werden.

5. Verfahren nach Anspruch 4, **dadurch gekennzeichnet,** daß ein digitaler Gleichstrom zum Eingangswert addiert und das Teilsignal des oberen Teilwertes gedämpft wird, wenn Eingangswerte kleiner als der digitale Gleichstrom sind.

6. Vorrichtung zur Durchführung des Verfahrens nach einem der Ansprüche 1 - 3, **dadurch gekennzeichnet,** daß das Eingangssignal einem Abtast-Halteglied (SH) zugeführt ist, dessen Ausgang mit dem Analogeingang eines M-Bit Parallel-A/D-Wandlers (FAD) verbunden ist, daß die Ausgänge des Parallel-A/D-Wandlers (FAD) mit den Digitaleingängen eines Referenz-D/A-Wandlers (RDA) und den höherwertigeren Eingängen eines L-Bit bistabilen Haltespeichers (L) verbunden sind, daß der Ausgang des Referenz-D/A-Wandlers (RDA) mit dem Ausgang dem Abtast-Haltegliedes (SH) in einem Differenzverstärker (DV) zusammengeführt ist, dessen Ausgang mit dem Analogeingang eines N-Bit Teilwert-A/D-Wandlers (AD) verbunden ist und daß die Ausgänge des Teilwert-A/D-Wandlers (AD) mit den niederwertigeren Eingängen des Haltespeichers (L) verbunden sind.

7. Vorrichtung nach Anspruch 6, **dadurch gekennzeichnet,** daß Eingänge einer Korrekturschaltung (KS) mit den Ausgängen des Parallel-A/D-Wandlers (FAD) verbunden sind, daß ein weiterer Eingang der Korrekturschaltung (KS) mit dem höchstwertigsten Ausgang des Teilwert-A/D-Wandlers (AD) verbunden ist, daß Ausgänge der Korrekturschaltung (KS) mit den höherwertigeren Eingängen des Haltespeichers (L) ein Überlastausgang mit Korrekturschaltung (KS) mit einem weiteren Eingang des Haltespeichers (L) und ein Steuerausgang der Korrekturschaltung (KS) mit einer Rauschunterdrückungsschaltung (NG1) verbunden sind und daß die Rauschunterdrückungsschaltung (NG1) zwischen den Referenz-D/A-Wandler (RDA) und den Differenzverstärker (DV) geschaltet ist.

8. Vorrichtung zur Durchführung des Verfahrens nach einem der Ansprüche 4 oder 5, **dadurch gekennzeichnet,** daß ein Datenbus (DB) für Eingangswerte mit einem Niederwert- und einem Oberwert-D/A-Wandler (LS-DAC, MS-DAC) verbunden ist, deren Ausgänge in einem Summierverstärker (SV) zusammengefaßt sind.

9. Vorrichtung nach Anspruch 8, **dadurch gekennzeichnet,** daß ein Gleichstromaddierer (NG2) zwischen dem Oberwert-D/A-Wandler (MS-DAC) und dem Summierverstärker (SV) angeordnet ist und daß er über einen Aufnahmespeicher (L1) mit dem Datenbus (DB) und über ein Gatter (G) mit dem Eingang des Oberwert-D/A-Wandlers (MS-DAC) verbunden ist.

10. Vorrichtung nach einem der Ansprüche 8 oder 9, **dadurch gekennzeichnet,** daß mit dem Aufnahmespeicher (L1) ein Übertragungsspeicher (L2) in Serie geschaltet ist.

Fig. 1

Fig. 2

EP 0 360 936 A1

| Europäisches Patentamt | **EUROPÄISCHER RECHERCHENBERICHT** | Nummer der Anmeldung |
|---|---|---|
| | | EP 88 30 9066 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.3) |
|---|---|---|---|
| X | ELECTRONIC DESIGN, Band 35, Nr. 2, 22. Januar 1987, Seiten 119-122, Hasbrouck Heights, NJ, US; M. KOEN: "Comparing ADC architectures is a designer's best bet" * Figur 4; Seite 122, linke Spalte, Zeilen 5-33 * | 1,2,6 | H 03 M 1/12 |
| A | Idem | 3,7 | |
| X | ELECTRONIC DESIGN, Band 28, Nr. 19, 13. September 1980, Seiten 93-98, Rochelle Park, Hasbrouck Heights, NJ, US; W.K. BUCKLEN: "Digitize with monolithic flash a-d converters" * Figur 4; Seite 96, Zeilen 4-35 * | 1,2,6 | |
| A | Idem | 3,7 | |
| X | ELEKTRONIK, Band 36, Nr. 8, 16. April 1987, Seiten 87-91, München, DE; W.-D. SCHLEIFER: "Keine Angst vor Stufen" * Figur 10; Seite 87, rechte Spalte, Zeile 4 - Seite 88, linke Spalte, Zeile 6 * | 1,2 | |
| A | Idem | 3,6,7 | |
| X | FUNKSCHAU, Nr. 7, März 1983, Seiten 57-60, München, DE; H. ZANDER: " Video in Bits" * Figuren 4-6; Seite 59, Zeile 1 - Seite 10, Zeile 83; Tabelle 3 * | 1,2 | |
| A | Idem | 3,6,7 | |

**RECHERCHIERTE SACHGEBIETE (Int. Cl.3)**

H 03 M

Der vorliegende Recherchenbericht wurde für alle Patentansprüche erstellt

| Recherchenort | Abschlußdatum der Recherche | Prüfer |
|---|---|---|
| DEN HAAG | 26-05-1989 | DE LA FUENTE DEL AGUA Y. |

EPO FORM 1503 03.82 (P0403)

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument